# DEMANDE DE BREVET EUROPEEN

(11) **EP 2 273 541 A1**
(43) Date de publication de la demande: **12.01.2011**
(21) Numéro de dépôt: 10169157.4
(22) Date de dépôt: 09.07.2010
(51) Int. Cl.: H01L 21/56, H01L 23/29

(54) **Puce de silicium à montage en surface par connexion à billes avec faces avant et arrière recouvertes d'une résine chargée**

(30) Priorité: 10.07.2009 FR 0954846
(71) Demandeur: STMicroelectronics (Tours) SAS, 37100 Tours (FR)
(72) Inventeur: Serre, Christophe, 37540 Saint Cyr Sur Loire (FR); Barreau, Laurent, 37130 Cinq Mars la Pile (FR); Jarry, Vincent, 37390 La Membrolle Sur Choisille (FR); Hougron, Patrick, 37210 Parcay Meslay (FR)
(74) Mandataire: de Beaumont, Michel

(57) **Abrégé**

L'invention concerne une puce de silicium (1) à montage en surface par l'intermédiaire de billes (5) fixées à sa face avant, dans laquelle les faces avant et arrière de la puce (1) sont recouvertes d'une couche de résine époxy thermodurcissable (11,13) présentant les caractéristiques suivantes :
- la résine contient une proportion de 45 à 60 % en poids d'une charge constituée de particules de fibres de carbone dont la taille maximum est de 20 µm et dont la plus grande partie a un diamètre compris entre 2 et 8 µm,
- du côté de la face avant, la résine chargée (11) recouvre 45 à 60 % de la hauteur des billes,
- du côté de la face arrière, la résine chargée (13) a une épaisseur comprise entre 80 et 150 µm.

## Description

### Domaine de l'invention

La présente invention concerne le domaine des circuits intégrés et plus particulièrement la protection d'une puce semiconductrice contre des chocs.

La présente invention s'applique plus particulièrement aux puces semiconductrices à montage en surface, c'est-à-dire des puces semiconductrices dont les plots de connexion portent des protubérances conductrices destinées à être accolées directement à des zones métalliques d'un support tel qu'une carte de circuit imprimé, ce type de montage étant généralement appelé montage flip chip.

### Exposé de l'art antérieur

Très souvent, dans un montage de type flip chip, pour minimiser l'encombrement, on utilise des puces nues, dont les surfaces sont seulement revêtues d'une mince couche isolante telle qu'une couche d'oxyde de silicium.

On utilise aussi des puces mises en boîtier qui sont alors encombrantes.

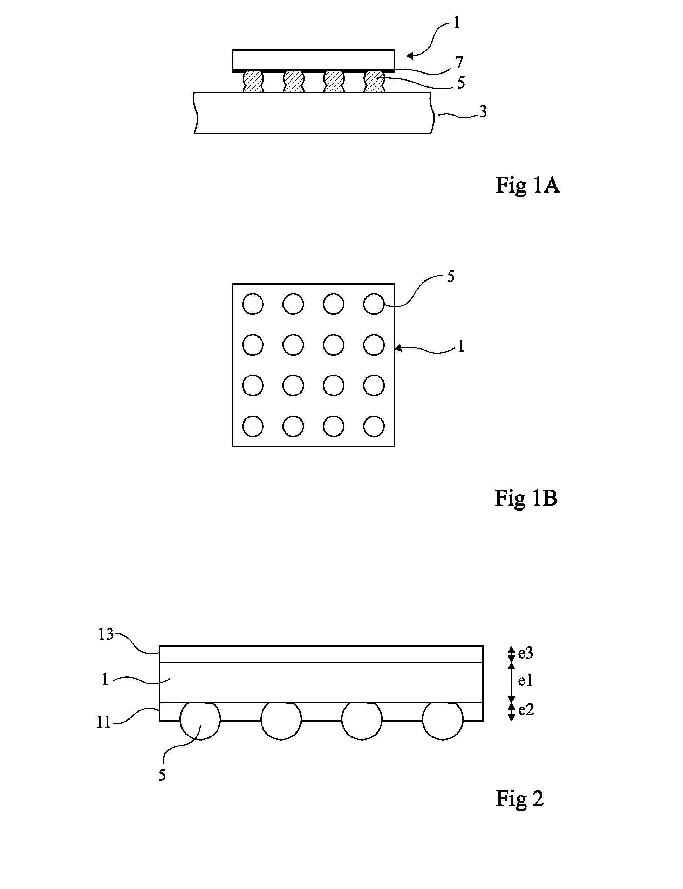

La figure 1A représente une puce à montage en surface 1 montée sur un circuit imprimé 3 par l'intermédiaire de billes 5 fixées, d'une part, à des plots de contact de la puce et, d'autre part, à des pistes d'une carte de circuit imprimé. La puce est une puce nue qui comprend seulement une mince couche d'un isolant 7 du côté de sa face avant (celle qui porte les billes de connexion).

La figure 1B est une vue de la face avant de la puce 1, dans un exemple dans lequel les billes de connexion 5 sont uniformément réparties en matrice sur toute la surface de la puce.

La présente invention concerne typiquement des puces sensiblement carrées ou rectangulaires de dimensions comprises entre 0,4 mm et 3 cm.

Ce type de montage a été très largement développé mais on s'aperçoit qu'il présente un risque de défaut important. Notamment, on s'aperçoit que des billes se fissurent au moment de leur mise en place sur le circuit imprimé ou après montage sur le circuit imprimé quand le dispositif contenant le circuit imprimé est soumis à des chocs (par exemple quand la puce est montée dans un circuit imprimé de téléphone portable et que l'utilisateur laisse tomber son téléphone sur une surface dure). La fissuration des billes entraîne des défauts de connexion et une défaillance immédiate du circuit, ou bien une défaillance progressive après une certaine durée d'utilisation.

### Résumé de l'invention

Un objet principal de modes de réalisation de la présente invention est de protéger des puces à montage en surface contre les conséquences de chocs et plus particulièrement contre des défauts des billes de connexions reliant les plots de la puce à des pistes d'un circuit imprimé.

La demanderesse a réalisé de nombreux essais et a trouvé une solution satisfaisante, qui consiste à revêtir les faces avant et arrière de la puce d'une couche de résine époxy thermodurcissable chargée de composition choisie, ces couches ayant des épaisseurs choisies dans des plages précises.

Plus particulièrement, un mode de réalisation de la présente invention prévoit une puce de silicium à montage en surface par l'intermédiaire de billes fixées à sa face avant, dans laquelle les faces avant et arrière de la puce sont recouvertes d'une couche de résine époxy thermodurcissable présentant les caractéristiques suivante :
- la résine contient une proportion de 45 à 60 % en poids d'une charge constituée de particules de fibres de carbone dont la taille maximum est de 20 µm et dont la plus grande partie a un diamètre compris entre 2 et 8 µm,
- du côté de la face avant, la résine chargée recouvre 45 à 60 % de la hauteur des billes,
- du côté de la face arrière, la résine chargée a une épaisseur comprise entre 80 et 150 µm.

Selon un mode de réalisation de la présente invention, la résine a, après durcissement un module d'Young compris entre 1 et 7 GPa.

Selon un mode de réalisation de la présente invention, les billes ont des diamètres de 200 à 300 µm.

Selon un mode de réalisation de la présente invention, les billes sont couramment en un alliage de brasure de type étain-argent-cuivre, la proportion pondérale d'argent et de cuivre étant inférieure à 10 %, par exemple 1 % d'argent et 0,5 % de cuivre.

Selon un mode de réalisation de la présente invention, la résine résulte d'un moulage par compression.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1A est une vue de côté d'une puce à montage en surface montée sur une carte de circuit imprimé ;
la figure 1B est une vue de dessus d'un exemple de face avant de puce à montage en surface ;
la figure 2 représente une puce à montage en surface selon un mode de réalisation de la présente invention ; et
les figures 3A à 3C illustrent des étapes successives d'un procédé selon un mode de réalisation de la présente invention de formation d'une couche de résine sur une puce à montage en surface.

Comme cela est usuel dans la représentation des composants microélectroniques, les diverses figures ne sont pas tracées à l'échelle mais sont uniquement destinées à faciliter la compréhension de la présente description.

### Description détaillée

La figure 2 représente un exemple de puce à montage en surface 1. La puce de silicium nue a une épaisseur de 100 à 500 µm. On appelle puce nue un morceau de tranche de silicium comprenant des régions de niveau et de type de dopage variés pour former des composants choisis. Cette puce nue inclut également divers niveaux de métallisation pour assurer les connexions entre composants et vers des plots de sortie. La puce nue est généralement revêtue de couches isolantes minces, par exemple de l'oxyde de silicium, dont les épaisseurs sont inférieures à 10 µm, couramment 1 à 3 µm. A cette puce nue, on a fixé des billes 5 qui ont couramment des diamètres de 200 à 300 µm qui sont couramment en des alliages de brasure de type étain-argent-cuivre, couramment désignés par l'abréviation SAC pour Sn, Ag, Cu. Ces billes sont constituées majoritairement d'étain, la proportion pondérale d'argent et de cuivre étant inférieure à 10 %, par exemple 1 % d'argent et 0,5 % de cuivre. Ces billes sont brasées sur les plots de connexion de la puce. Ainsi, si les billes ont initialement un diamètre de 300 µm, elles vont ensuite déborder de la surface de la puce d'une hauteur d'environ 200 à 250 µm.

Les plots peuvent être répartis uniformément comme cela est représenté dans la vue de face de la figure 1B, ou bien peuvent être disposés de toute autre manière, par exemple selon deux lignes parallèles, ou encore en formant un cadre entourant la puce, sans billes centrales.

Une couche de résine thermodurcissable 11 est déposée du côté de la face avant de la puce de façon à laisser émerger une protubérance de chacune des billes 5. Une couche de résine thermodurcissable 13 est déposée du côté de la face arrière de la puce 1.

Les deux couches de résine thermodurcissable sont des couches de résine époxy chargées par des morceaux de fibres de carbone. Les morceaux de fibre de carbone ont une longueur inférieure à 20 µm et ont, dans leur grande majorité, un diamètre compris entre 2 et 8 µm.

La couche de résine époxy chargée 11 formée sur la face avant de la puce a une épaisseur (e2) propre à recouvrir 45 à 60 % de la hauteur des billes fixées à la puce, de préférence 50 à 55 %. Ainsi, pour des billes de 300 µm, ayant une hauteur par rapport à la puce après fixation de l'ordre de 250 µm, la couche de résine aura une épaisseur de l'ordre de 125 µm. La couche de résine époxy chargée 13 disposée sur la face arrière de la puce est de préférence constituée de la même résine, chargée de la même manière que la couche de résine 11 déposée sur la face avant. Comme on le verra ci-après, les couches de résine 11 et 13 sont déposées sur les puces alors qu'elles sont encore assemblées en une tranche unique, avant découpe de cette tranche. La couche de résine 13 a essentiellement pour rôle d'équilibrer les tensions éventuellement appliquées à la tranche, par suite notamment des opérations de recuit de résine, qui tendraient à provoquer un gauchissement de la tranche qui nuirait à la bonne réalisation des opérations de découpe ultérieures. Ainsi, la couche 13 de face arrière aura une épaisseur (e3) du même ordre de grandeur que la couche de face avant 11. La couche 13 aura une épaisseur supérieure à 50 µm et inférieure à 200 µm, de préférence comprise entre 80 et 150 µm.

Par ailleurs, la nature de la résine époxy thermodurcissable chargée est choisie pour que, une fois chargée de la façon indiquée ci-dessus, et après durcissement, son module d'Young soit compris entre 1 et 7 GPa.

Etant donné les caractéristiques de la résine, il apparaît qu'il a été impossible de former les couches de résine par des procédés classiques de moulage par injection. La demanderesse a étudié et tenté avec succès un procédé de moulage par compression.

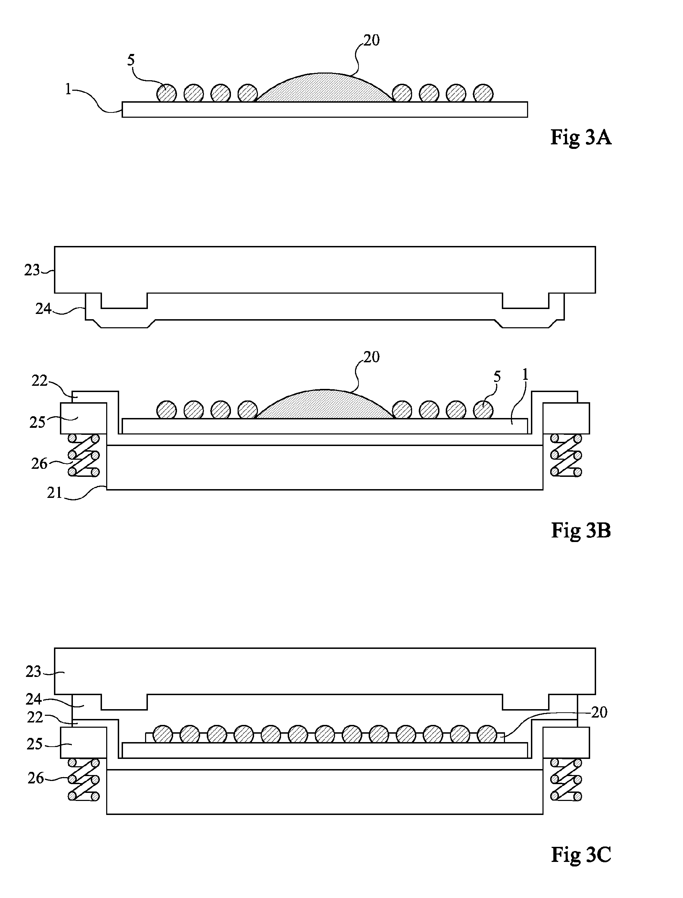

Les figures 3A à 3C illustrent les étapes successives d'un procédé de moulage par compression préconisé.

En figure 3A, sur la face avant d'une tranche de silicium 1 comportant les composants et munie de billes de connexion 5, est déposée une dose 20 de résine époxy chargée. Bien que l'on ait représenté seulement un petit nombre de billes 5, la figure 3A représente une tranche de silicium comprenant un grand nombre de puces, chaque puce portant un grand nombre de billes. Ainsi, en fait, si l'on avait voulu être à l'échelle il aurait fallu représenter une dimension de tranche beaucoup plus grande.

En figure 3B, la tranche 1 est posée sur la partie inférieure 21 d'un moule revêtue d'un film amortisseur 22. On a également représenté de façon disjointe la partie supérieure 23 du moule revêtue d'un film amortisseur 24. L'épaisseur et la souplesse du film 24 sont choisies pour que, lors de la compression de la partie haute sur la partie basse, ce film vienne épouser le motif constitué par les faces supérieures des billes 5. Le film 24 encapsule alors une partie supérieure des billes.

Le moule à l'état fermé et comprimé est représenté en figure 3C. Il est prévu des moyens de butée 25, éventuellement montés sur ressort 26, pour optimiser la compression et la limiter. A l'étape représentée en figure 3C, on voit le film 24 qui entoure et protège les parties hautes des billes non revêtues de résine.

Dans ce procédé de moulage par compression, la dose de résine 20 appliquée à l'étape illustrée dans la figure 3A est ajustée avec précision pour que, à l'étape de la figure 3C, on ait un étalement satisfaisant de la résine.

Un avantage de ce procédé par compression est qu'il ne se produit pas de ségrégation des charges (morceaux de fibres de carbone) qui sont régulièrement réparties dans la résine mise en place.

L'application de résine sur la face arrière de la tranche peut être faite de façon similaire par un procédé par compression.

La demanderesse a fait des essais de chocs sur les billes avec des puces constituées de façon décrite ci-dessus et avec des puces dans lesquelles il existait une couche de protection d'épaisseur inférieure à la demi épaisseur des billes, ou bien une couche de protection d'une épaisseur de l'ordre de la demi hauteur des billes, mais sans résine chargée.

On a constaté qu'alors que la plupart des dispositifs antérieurs présentaient des défauts de billes après un nombre de chocs inférieurs à 10, le dispositif tel que présenté ici ne présentait des défauts de billes qu'après un nombre de chocs supérieur à 30.

## Revendications

1. Puce de silicium à montage en surface par l'intermédiaire de billes (5) fixées à sa face avant, dans laquelle les faces avant et arrière de la puce sont recouvertes d'une couche de résine époxy thermodurcissable présentant les caractéristiques suivante :
- la résine contient une proportion de 45 à 60 % en poids d'une charge constituée de particules de fibres de carbone dont la taille maximum est de 20 µm et dont la plus grande partie a un diamètre compris entre 2 et 8 µm,
- du côté de la face avant, la résine chargée (11) recouvre 45 à 60 % de la hauteur des billes,
- du côté de la face arrière, la résine chargée (13) a une épaisseur comprise entre 80 et 150 µm.

2. Puce de silicium selon la revendication 1, dans laquelle la résine a, après durcissement, un module d'Young compris entre 1 et 7 GPa.

3. Puce de silicium selon la revendication 1 ou 2, dans laquelle les billes (5) ont des diamètres de 200 à 300 µm.

4. Puce de silicium selon l'une quelconque des revendications 1 à 3, dans laquelle les billes (5) sont couramment en un alliage de brasure de type étain-argent-cuivre, la proportion pondérale d'argent et de cuivre étant inférieure à 10 %, par exemple 1 % d'argent et 0,5 % de cuivre.

5. Puce de silicium selon l'une quelconque des revendications 1 à 4, dans laquelle la résine résulte d'un moulage par compression.

## Revendications modifiées

### Revendications modifiées conformément à la règle 137(2) CBE.

**1.** Puce de silicium à montage en surface par l'intermédiaire de billes (5) fixées à sa face avant, dans laquelle les faces avant et arrière de la puce sont recouvertes d'une couche de résine époxy thermodurcissable présentant les caractéristiques suivantes :
- la résine contient une proportion de 45 à 60 % en poids d'une charge constituée de particules de fibres de carbone dont la taille maximum est de 20 µm et qui ont dans leur grande majorité un diamètre compris entre 2 et 8 µm,
- du côté de la face avant, la résine chargée (11) recouvre 45 à 60 % de la hauteur des billes,
- du côté de la face arrière, la résine chargée (13) a une épaisseur comprise entre 80 et 150 µm.

**2.** Puce de silicium selon la revendication 1, dans laquelle la résine a, après durcissement un module d'Young compris entre 1 et 7 GPa.

**3.** Puce de silicium selon la revendication 1 ou 2, dans laquelle les billes (5) ont des diamètres de 200 à 300 µm.

**4.** Puce de silicium selon l'une quelconque des revendications 1 à 3, dans laquelle les billes (5) sont en un alliage de brasure de type étain-argent-cuivre, la proportion pondérale d'argent et de cuivre étant inférieure à 10 %.

**5.** Puce de silicium selon la revendication 4, dans laquelle la proportion pondérale d'argent et de cuivre est de 1 % d'argent et 0,5 % de cuivre.

**6.** Procédé de fabrication d'une puce de silicium selon l'une quelconque des revendications 1 à 4, comprenant l'étape consistant à mouler la résine par compression.
